Europäisches Patentamt

European Patent Office

Office européen des brevets

(11) Publication number:

**0 304 272**
**A2**

(12) # EUROPEAN PATENT APPLICATION

(21) Application number: 88307586.3

(22) Date of filing: 16.08.88

(51) Int. Cl.⁴: **G 01 V 3/10**
**H 03 K 17/95**

(30) Priority: 17.08.87 GB 8719422

(43) Date of publication of application:
22.02.89 Bulletin 89/08

(84) Designated Contracting States: DE FR GB

(71) Applicant: **SIGMA LIMITED**
**Spring Road**
**Letchworth Herts SG6 4AJ (GB)**

(72) Inventor: **Senensieb, Gideon**
**9 Lawrance Lea**
**Harston Cambridge CB2 5QR (GB)**

(74) Representative: **Loughrey, Richard Vivian Patrick et al**
**HUGHES CLARK & CO 63 Lincoln's Inn Fields**
**London WC2A 3JU (GB)**

(54) **Inductive proximity sensor.**

(57) An inductive proximity detector includes an oscillator circuit (11) including a coil (10) to which is electromagnetically coupled a sensing coil (12) and a reference coil (13). The sensing and reference coils are connected in series in opposition with the free end of the reference coil connected to ground. The common point (14) between the coils is connected through an amplifier (15) and detector (16) to one input (17) of a differential amplifier (18). The free end of the sensing coil is connected through an amplifier (20) and detector (21) to a second input (22) of the differential amplifier (18). In the absence of an object the output from the amplifier (18) will be zero. When an object is in proximity to the sensing coil the voltages induced in the coils is no longer equal and the amplifier (18) provides an output signal which is dependent upon the proximity of the object but is independent of the magnitude of current in the coil (10).

FIG.1.

EP 0 304 272 A2

# Description

## INDUCTIVE PROXIMITY SENSOR

This invention relates to inductive proximity sensors for the detection of the proximity of electrically conductive material.

Known inductive proximity sensors operate by inducing eddy currents in the material of an object being detected and then detecting the proximity of the material by the dissipation of power in the material. In such sensors a sensing coil forms part of a resonant circuit of an oscillator circuit. When an electrically conductive object approaches the coil, the alternating magnetic field generated by the oscillating current in the coil induces eddy currents in the electrically conductive material. This induction of eddy current causes dissipation of some of the electrical power generated by the oscillator circuit and as a consequence the output of the oscillator is attenuated. Hence the magnitude of the output of the oscillator provides an indication of the proximity of the electrically conductive object. Usually the attenuation of the output compared with the normal unattenuated output is detected and used to trigger a change of state in a switching device when the attenuation reaches a predetermined value or the proximity of the object may be indicated in some other way.

A disadvantage of known sensing devices is that they are sensitive to stray losses in the sensing coil. Such losses may arise due to the resistance of the wire from which the coil is constructed or due to hysteresis losses in any core material provided for the coil. Temperature changes can result in significant changes to the object. Consequently the circuit is unable to distinguish between stray losses and proximity of an object and due to the unpredictable variation of such losses the sensitivity of the device to the proximity of an object will vary and lead to loss of accuracy of the device.

According to the invention an inductive proximity sensor includes an oscillator circuit and a first coil energisable by said oscillator circuit and is characterised by a sensing coil electro-magnetically coupled to the first coil; means responsive to voltages induced in the sensing coil to provide an indication of proximity to the sensing coil of an electrically conductive object; and means responsive to current in the first coil to generate a reference signal; and further means operative in response to said reference signal to maintain said indication signal substantially independent of stray changes in circuit characteristics.

Preferably the means responsive to current in the first coil includes a reference coil electro-magnetically coupled to the first coil and the sensing coil and the reference coil are connected in series in opposition.

Conveniently the first coil may be disposed between the sensing and reference coils.

A differential amplifier responsive to voltages induced in the sensing coil and the reference coil may be utilised to provide an indication of the proximity to the sensing coil of an electrically conductive object substantially independent of current flow in the first coil.

A variable resistance may be provided in the oscillator circuit to control current flow in the first coil and means operative to vary said resistance in dependence upon the magnitude of said reference signal may be provided to maintain the current flow in the first coil at a uniform magnitude.

Alternatively the means responsive to current flow in the first coil may include a resistance connected in series with said first coil and means responsive to voltage induced in the sensing coil and to voltage across said resistance provides an indication signal substantially independent of current flow in the first coil.

An embodiment of the invention will be described by way of example with reference to the drawing in which:-

Figure 1 is a circuit diagram of an inductive proximity sensor and

Figure 2 is a circuit diagram of a modified inductive proximity sensor.

A coil 10 forms part of a resonant circuit of an oscillator 11. Secondary coils 12 and 13 are electromagnetically coupled to the coil 10. These coils 12, 13 have substantially identical electrical characteristics and have substantially similar coupling with coil 10. The coils 12, 13 are connected in series in opposition. The coil 12 is used as a sensing coil and is located so as to be closest to the object being detected while the other coil 13 is used as a reference coil and is located so as to be furthest from the object. The common point 14 between coils 12, 13 is connected to the input of an amplifier 15. The output of amplifier is fed to a detector 16 and thence to one input 17 of a differential amplifier 18. Similarly the free end 19 of coil 12 is connected to the input of an amplifier 20. The output of amplifier 20 is fed to a detector 21 and thence to a second input 22 of the differential amplifier 18. The free end 23 of coil 13 is connected to ground.

It will be understood that in the absence of an object, electro-motive forces induced in the coils 12, 13 by a magnetic field generated by the coil 10 will be substantially equal and of opposite polarity and hence the voltage at the input 22 of the differential amplifier 18 will be substantially zero. When an electrically conductive object approaches the coil 12, eddy currents will be induced in it by the field of coil 10 and the electro-motive forces induced in the coils 12, 13 will no longer be equal. As a result the voltage at the input 22 of the differential amplifier is no longer zero. The output from the differential amplifier 18 provides a signal which is indicative of the proximity of an electrically conductive object to the sensing coil 12.

The voltages induced in both the coils 12 and 13 are proportional to the current in the coil 10 and hence the output of the differential amplifier 18 is largely independent of the magnitude of the current in the coil 10. As a result the accuracy of the sensor is largely unaffected by such stray losses and any changes thereto.

Preferably the coils 10, 12 and 13 are coaxial with the coils 12, 13 being axially spaced and coil 10 disposed between the coils 12 and 13. If desired an element of conductive material may be positioned adjacent the reference coil 13 and movable relative to the coil 13 to enable the balancing of the coil arrangement to be adjusted.

In an alternative arrangement instead of providing the coil 13 as a source of reference voltage to the differential amplifier, a temperature stable resistance is included in series with the coil 10 so that any current through the coil also flows through the resistance. The voltage drop across the resistance is fed to the input 17 of the differential amplifier 18. Thus any change in the current in the coil 10, which would result in a change in the voltage induced in sensing coil 12, also generates a change in the voltage across the resistance so that the output of the differential amplifier is substantially unchanged by change of current in the coil 10.

In another arrangement instead of using a differential amplifier to produce a resultant output from a sensing coil and a reference coil, the amplified and rectified voltage from detector 16 is used to control the magnitude of resistance of a voltage dependent resistor in the oscillator circuit 11. This resistor is located in the oscillator circuit in such a manner that any tendency for the current in the coil 10 to change is compensated by change of the magnitude of resistance of the resistor to maintain the current in the coil 10 substantially constant.

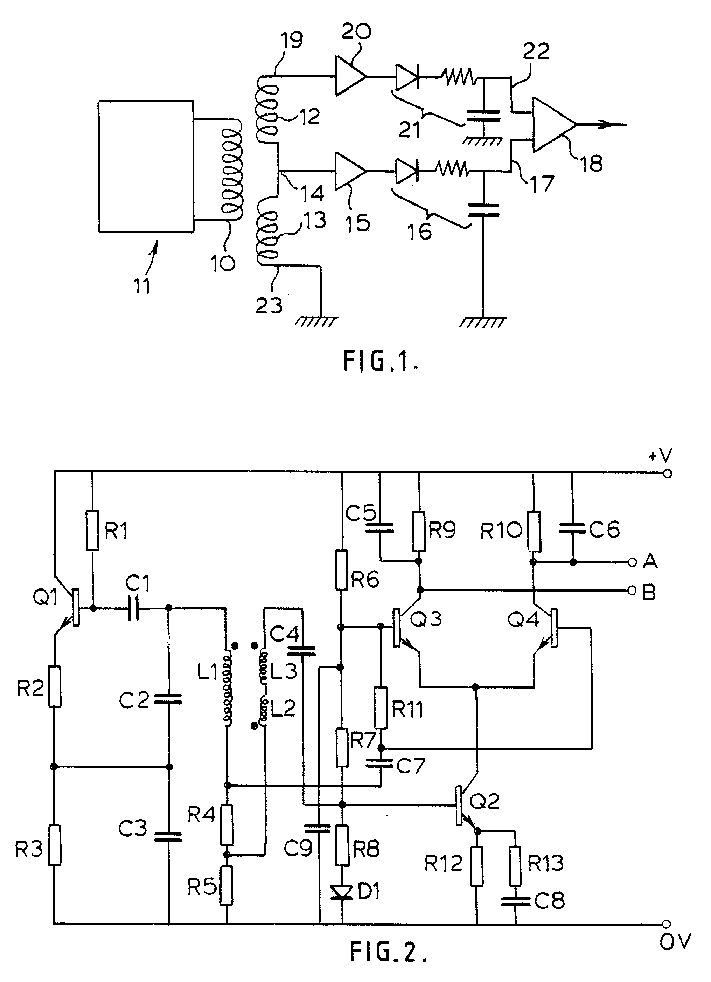

In the construction of sensor described hereinbefore with reference to Figure 1 it has been found that a very high degree of balance between the two secondary coils 12 and 13 in their mutual coupling with the primary coil 10 is required in order to achieve high sensitivity. Any intrinsic imbalance signal, in the absence of an object in the proximity of the sensor, detracts from the signal derived from the approach of an object. Any imbalance signal can be considered as consisting of two components. One component is in phase with the current in the primary coil 10 and the other component is 90° out of phase, i.e. in quadrature, with the current in the primary coil. In the absence of a target object the in phase component of the imbalance signal is zero and hence the intrinsic imbalance signal consists solely of the quadrature component. A metal target object in proximity to the sensor results in an imbalance signal consisting of both in phase and quadrature components. The relative magnitudes of the two components is dependent upon the composition of the metal target object and circuit parameters such as diameter of the coils and the frequency of the excitation signal from the oscillator. The sensor circuit shown in Figure 2 uses synchronous detection arranged such that the output signal is dependent solely upon the in phase component. Hence the magnitude of the intrinsic imbalance signal, consisting of the quadrature component only, is of less significance and as a result the coils may be constructed with less precision.

Referring now to Figure 2, an oscillator is formed by transistor Q1, resistors R1, R2 and R3, capacitors C1, C2 and C3 and primary coil L1. The oscillator shown in the drawing is a form of Colpitts oscillator. The operation of the oscillator in generating a sinewave of frequency determined by the capacitors C2 and C3 and the inductance of coil L1 is well known and hence will not be described herein. The form of oscillator is not of importance in relation to the invention and other forms of oscillator circuit may be used if desired. A pair of secondary coils L2, L3 are connected in series and are electromagnetically coupled to the primary coil L1. The construction and electrical connections of the coils L1, L2 and L3 is the same as that of the coils 10, 11 and 12 of the circuit shown in Figure 1.

A synchronous detector is formed by transistors Q3 and Q4 with transistor Q2 acting as a current source. The emitters of transistors Q3 and Q4 are connected to the collector of transistor Q2, while the emitter of transistor Q2 is connected to ground through a resistor capacitor combination consisting of resistors R12 and R13 and capacitor C8. Resistors R4, R5 are connected in series with the primary coil L1 and the voltage across these resistors is applied through a decoupling capacitor C7 to the base of transistor Q4 as a reference signal. Since these resistors R4 and R5 are in series with the coil L1, the sinewave voltage waveform across the resistors is in phase with the current waveform through the coil L1. The voltage waveform applied to the base of transistor Q4 causes transistor Q4 to turn on during the positive half cycle and to turn off during the negative half cycle. The collector of transistor Q4 is connected to a positive supply +V through a resistor R10. A by-pass capacitor C6 is connected across resistor R10. Similarly the collector of transistor Q3 is connected through resistor R9 to the positive supply and the resistor is by-passed by capacitor C5. Thus when the transistor Q4 is turned on during the positive half cycle, current flowing into the collector of Q2 is drawn through R10 and C6. The base of transistor Q3 is held at a potential determined by the resistor and diode chain R6, R7, R8 and D1. The base is decoupled to ground by capacitor C9. When the transistor Q4 is turned off the transistor Q3 is able to conduct. When the transistor Q4 is turned on the current drawn through the emitter of transistor Q4 causes the transistor Q3 to be turned off. Thus when the transistor Q4 is turned off during the negative half cycle the current flowing into the collector of transistor Q2 is drawn through Q3, R9 and C5

The secondary coils L2, L3 are connected in opposition and one end of coil L2 is connected to the junction of R4 and R5. The corresponding end of coil L3 is connected via decoupling capacitor C4 to the base of transistor Q2. The base of transistor Q2 is biased to a DC potential determined by the potential at the junction of the resistors R7 and R8. Accordingly a voltage waveform which consists of the superposition of an in phase voltage across resistor R5 and any imbalance voltage across the series connected secondary coils L2, L3 is applied to the base of transistor Q2 and modulates the current through transistor Q2. Thus the voltage between output terminals A and B, connected respectively to the collectors of transistors Q3 and Q4, is proportional to the amplitude of the in-phase component of the voltage on the base of transistor Q2.

The connections to the secondary coils L2 and L3 are arranged such that the in-phase voltage imbalance signal due to proximity of a target object is opposite in sign to the voltage waveform across R5. The value of resistance of resistor R5 is selected such that the instantaneous voltage across it is equal in magnitude and hence cancels the instantaneous in-phase imbalance voltage across the secondary coils L2, L3 when a standard target object is at a predetermined sensing distance from coils. Thus when a target object is present at the predetermined distance the voltage between terminals A and B will have a predetermined magnitude. If the target object is nearer to or more distant from the coils than the predetermined distance, the voltage between terminals A and B will be higher or lower than the predetermined magnitude. The presence or absence of a target object at the predetermined distance from the coils can therefore be detected by connecting the terminals A and B to a comparator responsive to the voltage between the terminals crossing the predetermined magnitude.

An additional benefit obtained from the circuit of Figure 2 is that it provides increased immunity to induced electrical noise signals from external sources. Such immunity is especially important in applications of the sensor where electrical interference is expected such as in places where electrical welding is carried out.

## Claims

1. An inductive proximity sensor including an oscillator circuit (11) and a first coil (10) energisable by said oscillator circuit characterised by a sensing coil (12)) electro-magnetically coupled to the first coil (10)); means (18) responsive to voltages induced in the sensing coil (12) to provide an indication of proximity to the sensing coil of an electrically conductive object; and means (13,15,16) responsive to current in the first coil (10) to generate a reference signal; and further means (18) operative in response to said reference signal to maintain said indication signal substantially independent of stray changes in circuit characteristics.

2. An inductive proximity sensor as claimed in claim 1 further characterised in that the means (13,15,16) responsive to current in the first coil includes a reference coil (13) electro-magnetically coupled to the first coil (10).

3. An inductive proximity sensor as claimed in claim 2 further characterised in that the sensing coil (12) and the reference coil (13) are connected in series in opposition.

4. An inductive proximity sensor as claimed in claim 2 or 3 further characterised in that the first coil 910) is disposed between the sensing and reference coils (12,13).

5. An inductive proximity sensor as claimed in claim 2, 3 or 4 further characterised by the provision of a differential amplifier (18) responsive to voltages induced in the sensing coil (12) and the reference coil (13) to provide an indication of the proximity to the sensing coil (12) of an electrically conductive object substantially independent of current flow in the first coil (10).

6. An inductive proximity sensor as claimed in claim 2, 3, 4 or 5 further characterised in that the oscillator (11) includes a variable resistance operative to control current flow in the first coil (10); and including means operative to vary said resistance in dependence upon the magnitude of said reference signal to maintain the current flow in the first coil (10) at a uniform magnitude.

7. An inductive proximity sensor as claimed in claim 1 further characterised in that the means responsive to current flow in the first coil includes a resistance connected in series with said first coil (10) and includes means (18) responsive to voltage induced in the sensing coil and to voltage across said resistance to provide an indication signal substantially independent of current flow in the first coil (10).

8. An inductive proximity sensor as claimed in claim 7 further characterised by the provision of a synchronous detector including first and second transistors (Q3,Q4) switchable alternately between conducting and non-conducting states by a reference voltage waveform generated across said resistor (R4,R5) in series with the first coil (L1) and further including a current source (Q2) for said first and second transistors (Q3,Q4); and means responsive to the sum of voltage induced in the sensing coil (L2) and at least a portion of said reference voltage to modulate the current source (Q2).

9. An inductive proximity sensor as claimed in claim 8 further characterised in that the voltage induced in the sensing coil (L2) is of opposite sign to the reference voltage.

10. An inductive proximity sensor as claimed in claim 9 further characterised in that the voltage induced in the sensing coil (L2) when an object to be sensed is located at a predetermined position relative to the sensing coil is of equal magnitude to the portion of said reference voltage.

FIG.1.

FIG.2.